Europäisches Patentamt

European Patent Office

Office européen des brevets

(11) Numéro de publication: **0 028 549**
**B1**

(12) **FASCICULE DE BREVET EUROPEEN**

(45) Date de publication du fascicule du brevet:
25.01.84

(51) Int. Cl.³: **H 03 G 5/04**, G 11 B 5/45

(21) Numéro de dépôt: 80401417.3

(22) Date de dépôt: 06.10.80

(54) Filtres accordés par commutation et utilisation dans un égaliseur d'enregistreur magnétique.

(30) Priorité: 31.10.79 FR 7926969

(43) Date de publication de la demande:
13.05.81 Bulletin 81/19

(45) Mention de la délivrance du brevet:
25.01.84 Bulletin 84/4

(84) Etats contractants désignés:
AT BE CH DE GB IT LI LU NL SE

(56) Documents cités:
FR - A - 1 429 880
FR - A - 1 556 557
FR - A - 2 374 773
US - A - 3 160 824
US - A - 3 289 095
US - A - 3 781 488
US - A - 3 940 709

WIRELESS WORLD, vol. 78, no. 1441, juillet 1972,
HEATH, Sussex (GB) J.B. COLE: "Remote switching of
tape equalization", page 348
JOURNAL OF THE AUDIO ENGINEERING SOCIETY, vol.
23, no. 1, janvier/février 1975, New York, U.S.A. ZOLTAN
VAJDA: "Low noise reproducing preamplifier for
professional audio recorders", pages 14-20

(73) Titulaire: **ENERTEC SOCIETE ANONYME, 12, Place des
Etats-Unis, F-92120 Montrouge (FR)**

(72) Inventeur: **Lelandais, Guy, 7, Bld des Oiseaux,
F-91440 Bure sur Yvette (FR)**

(74) Mandataire: **Bentz, Jean-Paul, GIERS SCHLUMBERGER
Service BREVETS 12, place des Etats-Unis,
F-92124 Montrouge Cedex (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit
être formée par écrit et motivée. Elle n'est réputée formée qu'après paiement de la taxe d'opposition (Art. 99(1) Convention sur le
brevet européen).

ACTORUM AG

Filtres accordés par commutation et utilisation dans un égaliseur d'enregistreur magnétique

La présente invention concerne des filtres accordés par commutation et plus précisément, bien que non exclusivement, des filtres accordés par commutation trouvant application dans les égaliseurs d'enregistreurs à bande magnétique.

Lors de la reproduction d'un signal électrique préalablement enregistré, les enregistreurs magnétiques reposent sur le principe de l'induction magnétique pour reproduire le signal électrique à partir d'un motif de magnétisation établi sur la bande magnétique au cours du processus d'enregistrement. Cependant, l'amplitude du signal de tension induit magnétiquement est proportionnelle à la vitesse de variation du champ magnétique de sorte que l'amplitude du signal électrique produit par la tête de lecture est non seulement fonction de l'amplitude du signal électrique original mais aussi de la fréquence de ce signal et de la vitesse de défilement de la bande sur la tête de lecture. Afin d'obtenir une reproduction fidèle du signal électrique original, le signal de la tête de lecture est appliqué à un filtre (connu sous le nom d'égaliseur) qui compense la distorsion introduite par le fait que le processus de reproduction dépend de la fréquence et de la vitesse. Un exemple d'un tel égaliseur est donné dans le brevet US n°. 3 781 488.

Comme le signal de la tête de lecture dépend en partie de la vitesse de la bande, il est courant de prévoir un circuit de filtrage individuel pour chaque vitesse de défilement possible, la réponse de chacun des filtres étant choisie de façon à correspondre à la réponse en fréquence de la tête de lecture à la vitesse de défilement respective. Bien sûr, dans un enregistreur magnétique multi-piste, il est nécessaire de prévoir un ensemble séparé de filtres couvrant la totalité de la gamme de vitesse de défilement pour chaque piste: c'est ainsi qu'un enregistreur à 8 pistes et à 8 vitesses nécessiterait 64 filtres individuels, par exemple, l'égaliseur du brevet US n°. 3 781 488 comprend quatre résistances ajustables par vitesse et par piste. En outre, la réponse en fréquence exacte diffère d'une piste à l'autre en raison des tolérances de fabrication affectant les têtes de lecture. Par conséquent, il peut s'avérer nécessaire que chaque filtre individuel comporte jusqu'à 4 ajustements individuels pour qu'il puisse être adapté avec précision à sa tête de lecture associée, ce qui nécessiterait quelques 256 ajustements pour la totalité de l'égaliseur. Cela entraîne des dépenses considérables tant en ce qui concerne le coût de l'incorporation de composants ajustables qu'en ce qui concerne le temps et le coût exigés par un nombre si élevé d'ajustements.

L'invention a pour objet de réduire le nombre et le coût de ces ajustements.

Selon l'invention, un filtre accordé par commutation trouvant application dans un égaliseur pour enregistreur à bande magnétique est caractérisé en ce qu'il comporte:
— une entrée pour recevoir un signal d'entrée;
— un filtre capacitif relié et répondant à ladite entrée pour fournir un premier signal filtré;
— un filtre résonnant relié et répondant à ladite entrée pour fournir un second signal filtré, ledit filtre résonnant comprenant un gyrateur et présentant une réponse en fréquence dépendant au moins en partie de valeurs des paramètres de circuit le long de deux trajets de circuit dans ledit gyrateur;
— des moyens de commutation prévus pour sélectionner différentes valeurs des paramètres de circuits pour au moins l'un desdits trajets;
— des moyens reliés et répondant audit filtre capacitif et audit filtre résonnant pour combiner lesdits premier et second signaux filtrés.

On entend ici par gyrateur un circuit sans self ayant des caractéristiques d'impédance analogues à celles d'une self.

Un dispositif de ce type permet d'abaisser à un par piste le nombre des filtres dans un égaliseur pour enregistreur à bande magnétique, chaque filtre ne nécessitant que deux ajustements.

En outre, si le filtre capacitif présente une courbe de réponse en fréquence purement capacitive, le même condensateur peut être utilisé dans ce filtre pour toutes les vitesses de défilement.

Il est préférable que les moyens de commutation soient prévus pour sélectionner diverses valeurs des paramètres du circuit pour chacun desdits trajets.

Les moyens de commutation peuvent être prévus pour sélectionner différentes valeurs de résistance dans l'un desdits trajets de circuit et diverses valeurs de capacité dans l'autre trajet et, en particulier, peuvent être prévus pour sélectionner des valeurs qui doublent successivement. Ledit autre trajet peut comporter des moyens de résistance variable en série avec lesdites capacités sélectionnables, cette résistance variable fournissant le premier ajustement, dans le cas d'un enregistreur à bande magnétique, pour tenir compte des variations de la réponse en fréquence d'une tête de lecture à l'autre.

Le filtre résonnant peut être relié auxdits moyens de combinaison par l'intermédiaire d'un amplificateur à gain variable qui constitue le second ajustement d'un enregistreur magnétique afin d'adapter la réponse en fréquence globale de l'égaliseur à celle de la tête de lecture.

Le filtre résonnant peut comprendre une capacité de valeur fixe en parallèle avec ledit gyrateur.

Les moyens de combinaison peuvent être prévus pour additionner lesdits premier et second signaux filtrés.

L'entrée peut être prévue pour fournir des signaux en opposition de phase à ce filtre capacitif et à ce filtre résonnant, respectivement.

Le filtre accordable par commutation peut comporter des moyens de commande d'amplitude reliés et répondant à ladite entrée pour fournir un signal commandé en amplitude, les moyens de combinaison étant reliés et répondant aux moyens de commande d'amplitude pour combiner le signal commandé en amplitude aux signaux filtrés. Dans ce cas, les moyens de commande d'amplitude peuvent être reliés aux moyens de combinaison par un dispositif permettant d'inverser sélectivement le signal commandé en amplitude pour fournir, dans le cas d'un enregistreur magnétique une compensation lorsqu'une bande magnétique est relue dans le sens opposé à celui dans lequel elle a été enregistrée.

Selon un autre mode de réalisation de l'invention, il est fourni un enregistreur magnétique caractérisé en ce qu'il comprend:

— un égaliseur comportant un filtre accordé par commutation tel que défini ci-dessus.

On décrira à présent à titre d'illustration de l'invention, un filtre accordé par commutation conforme à l'invention dans un égaliseur faisant partie d'un enregistreur magnétique, en se référant aux dessins annexés dans lesquels:

— la figure 1 est un diagramme schématique d'une partie d'un enregistreur à bande magnétique, représentant le circuit de l'égaliseur; et

— la figure 2 représente les courbes de réponse en fréquence d'une tête de lecture et de l'égaliseur.

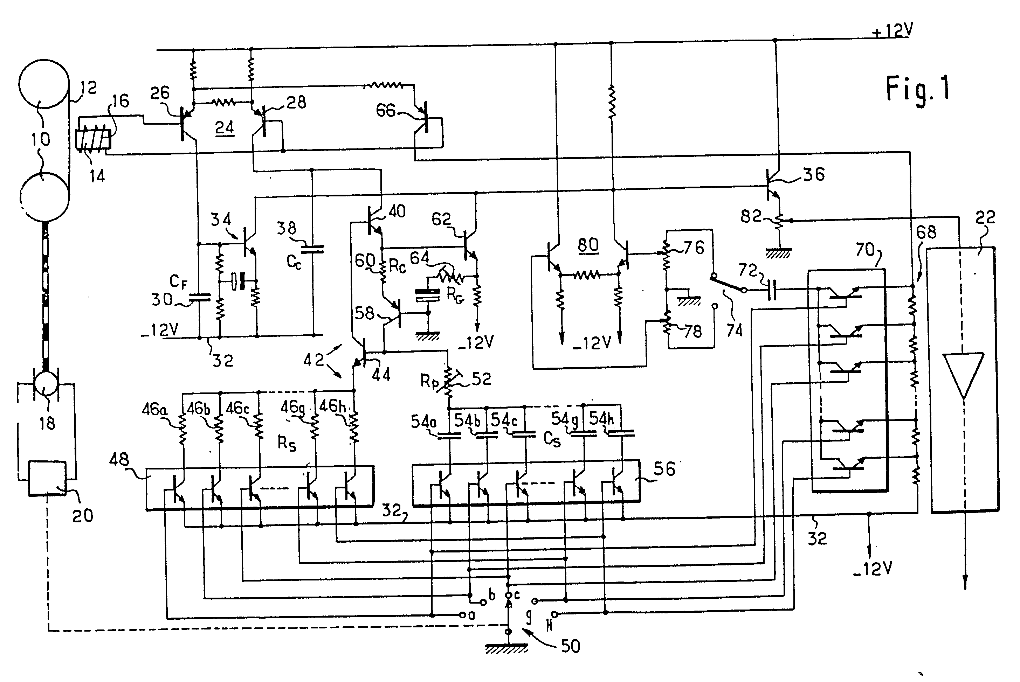

La figure 1 représente sous forme d'un diagramme un enregistreur à bande magnétique comportant deux bobines 10 portant une bande magnétique 12 passant de l'une des bobines 10 à l'autre, devant une tête de lecture 14. (Pour plus de commodité et de clarté les têtes d'enregistrement et d'effacement ainsi que les circuits qui leur sont associés et qui font également partie d'un enregistreur magnétique, n'ont pas été représentés dans la figure 1). La tête de lecture 14 comprend plusieurs bobines à raison d'une par piste enregistrée sur la bande 12, disposées dans le sens de la largeur de la bande 12 et par conséquent, perpendiculairement au plan de la figure 1, dans laquelle on n'a représenté qu'une seule de ces bobines, 16, pour plus de clarté.

Un moteur électrique 18 (par exemple, un moteur pas à pas) est relié mécaniquement aux bobines 10 pour les entraîner en réponse à un signal pulsé produit par une unité de commande 20. La fréquence de répétition des impulsions de ce signal peut être choisie manuellement de façon à faire varier la vitesse du moteur 18 et, ainsi, la vitesse à laquelle la bande 12 défile devant la tête de lecture 14.

Comme mentionné précédemment, la réponse en fréquence d'une tête de lecture n'est pas constante mais varie en fonction de la fréquence d'inversion (et, par conséquent, de la vitesse de variation) du champ magnétique traversant la tête de lecture. Cette fréquence dépend à son tour à la fois de la fréquence du signal enregistré et de la vitesse de défilement de la bande 12 devant la tête de lecture 14.

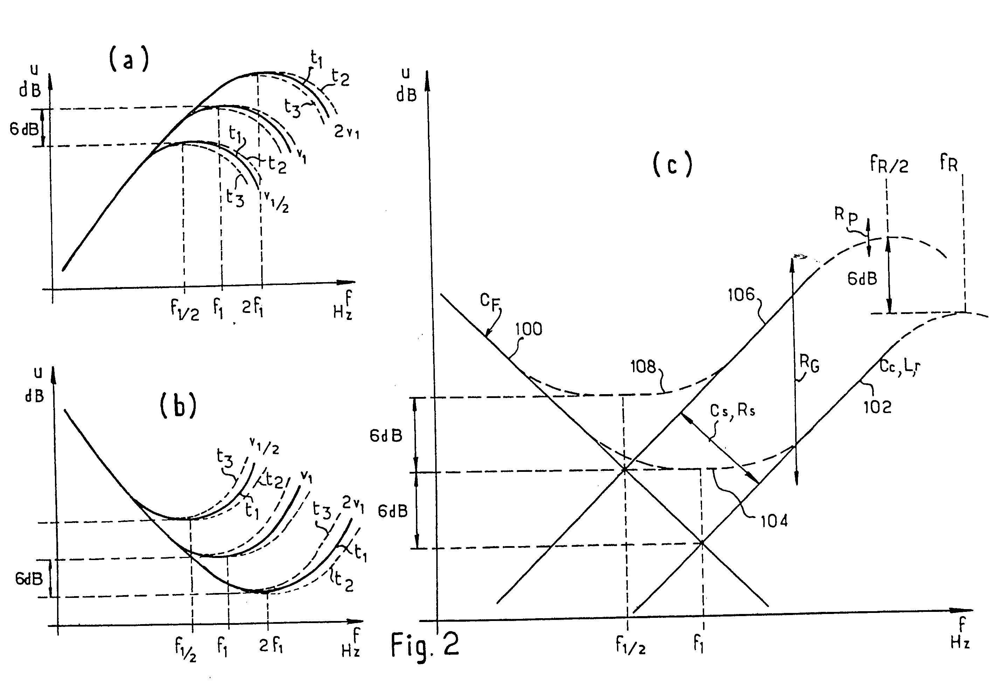

La figure 2 (a) indique la forme générale de la réponse en fréquence de la tête de lecture 14 pour un signal enregistré d'amplitude constante, en fonction de la fréquence $f$ du signal et de la vitesse de défilement $v$ de la bande. On peut constater que pour une vitesse donnée $v_1$, l'amplitude $u$ du signal de la tête de lecture augmente avec la fréquence jusqu'à un maximum à une fréquence $f_1$, puis diminue de nouveau. Pour une vitesse double (c'est à dire $2 v_1$) le même signal enregistré produit une réponse ayant la même forme mais avec un pic à une fréquence $2 f$ et l'amplitude supérieure de 6dB. De même, à une vitesse $v_1/2$, le pic se situe à $f_1/2$ et présente une amplitude inférieure de 6 dB à celle obtenue à la vitesse $v_1$. Les courbes en trait continu de la figure 2 (a) représentent les réponses en fréquence d'une bobine «moyenne» associée à une piste $t_1$ sur la bande

12. Les variations dues aux tolérances de fabrication peuvent conduire au fait que la réponse en fréquence obtenue pour une autre piste $t_2$ soit légèrement, mais significativement plus importante aux fréquences élevées et que celle obtenue pour une troisième piste $t_3$ soit légèrement mais significativement inférieure.

Pour compenser la non linéarité de la réponse en fréquence de la tête de lecture 14, on incorpore habituellement un égaliseur entre la tête 14 et le reste des circuits d'enregistrement (représentés d'une manière générale en 22 dans la figure 1). En général, les égaliseurs connus comportent pour chaque piste, un ensemble distinct de filtres, chacun des filtres fournissant l'une des réponses en fréquence représentées dans la figure 2 (b) et correspondant respectivement à l'une des vitesses de défilement telles que $v_1$, $2 v_1$ ou $v_1/2$. Chacun des filtres doit donc comporter des ajustements à la fois pour tenir compte des tolérances sur composants (en particulier les bobines) qui le constituent, mais surtout pour pouvoir adapter les filtres de l'un quelconque de ces ensembles à la réponse en fréquence particulière de la piste à laquelle ils sont associés, c'est à dire $t_1$, $t_2$, ou $t_3$. Il en résulte que les égaliseurs classiques mettent en jeu une centaine d'ajustements individuels et qu'ils sont très onéreux du point de vue de leur fabrication et de leur ajustement en vue d'un fonctionnement correct.

La figure 1 est un circuit diagramme d'un canal d'un égaliseur qui résoud dans une large mesure ce problème. Il est à noter que chacune des pistes enregistrées sur la bande 12 nécessite un circuit identique.

En se référant à la figure 1, la bobine 16 de la tête de lecture 14 est reliée à un amplificateur différentiel 24 comportant deux transistors 26 et 28 dont les émetteurs sont reliés, à travers une résistance, à un conducteur à $+ 12$ V. Le collecteur du transistor 26 est relié à une première borne d'un condensateur 30 dont la valeur est de $C_f$ microfarads, l'autre borne du condensateur 30 étant reliée également par l'intermédiaire d'un amplificateur séparateur 34 à la base d'un transistor de sortie 36.

Le collecteur du transistor 28 est relié à la fois à une première borne d'un condensateur 38 et au collecteur d'un transistor 40 qui constitue l'entrée d'un gyrateur 42. L'autre borne du condensateur 38 dont la valeur est de $C_c$ microfarads, est reliée au conducteur à $- 12$ V 32.

Dans le gyrateur 42 la base du transistor 40 est reliée au collecteur d'un transistor 44 dont l'émetteur est relié à un groupe de résistances 46a à 46h à tolérances serrées. La valeur ($R_s$ ohms) de chacune des résistances 46b à 46h est égale à la moitié de chacune des résistances précédentes 46a à 46g. Les résistances 46a à 46h sont reliées au conducteur négatif 32 par des commutateurs électroniques respectifs (tels que des transistors bipolaires) dans un réseau 48 les bornes de commande de ces commutateurs étant reliées aux bornes respectives a à h d'un commutateur multivoies 50.

La base du transistor 44 est reliée par un rhéostat préréglé 52 (valeur: $R_P$ ohms) à un groupe de condensateurs 54a à 54h à tolérances serrées, la valeur

($C_s$ microfarads) de chaque condensateur 54b à 54h étant la moitié de celle de son prédécesseur 54a à 54g dans le groupe. Les condensateurs 54a à 54h sont reliés au conducteur négatif 32 par des commutateurs électroniques respectifs dans un réseau 56. Les bornes de commande de ces commutateurs étant reliées aux bornes a à h du commutateur 50.

La base du transistor 44 est aussi reliée via le trajet collecteur-émetteur d'un transistor 58 (dont la base est reliée à la terre) et une résistance 60 (valeur $R_c$ ohms) à l'émetteur du transistor 40 dont le collecteur est relié au collecteur du transistor 28. L'émetteur du transistor 40 constitue la sortie du gyrateur 42 et est relié par l'intermédiaire de la jonction base-collecteur d'un transistor séparateur 62 à la base du transistor de sortie 36. L'émetteur du transistor séparateur 62 est relié au conducteur à −12 V 32 par une résistance et à la terre par un rhéostat de préréglage 64 (valeur: $R_G$ ohms) et un condensateur. Le réglage du rhéostat 64 commande le gain de l'amplificateur séparateur constitué par le transistor 62.

Le transistor 28 de l'amplificateur différentiel est en parallèle avec un transistor 66 dont le collecteur est relié à une extrêmité d'un diviseur de potentiel résistif 68. L'autre extrêmité du diviseur de potentiel 68 est reliée au conducteur à −12 V 32 et les jonctions intermédiaires le long de l'échelle 68 sont reliées par des commutateurs électroniques respectifs d'un réseau 70 à un condensateur de couplage commun 72. Les bornes de commande des commutateurs du réseau 70 sont reliées aux bornes respectives a à h du commutateur 50 de telle manière que le commutateur correspondant à la jonction de l'échelle 68 la plus proche du conducteur 32 soit commandé par la borne h.

Un inverseur bipolaire 74 relie le condensateur 72 à l'un ou l'autre de 2 potentiomètres 76 et 78 dont les bornes sont couplées et reliées à la terre. Les curseurs de ces potentiomètres 76 et 78 sont reliés aux entrées respectives inverseuse et non inverseuse d'un amplificateur différentiel 80 dont la sortie est reliée à la base du transistor de sortie 36.

Ce transistor de sortie 36 est branché en mode émetteur suiveur avec un potentiomètre 82 entre son émetteur et la terre, le curseur du potentiomètre 82 étant relié au reste du circuit 22 de l'enregistreur magnétique.

Le balai du commutateur 50 est relié à l'unité de commande 20 pour sélectionner respectivement l'une des bornes a à h en fonction de la vitesse de défilement choisie; en particulier, lorsque la vitesse de défilement est doublée, la borne suivante (dans le sens a vers h) est choisie. Le balai lui-même est électriquement relié à la terre de façon à ce qu'il ferme les commutateurs électroniques à raison d'un dans chacun des réseaux 48, 56 et 70 auxquels il est relié par la borne sélectionnée. Ainsi, seulement l'une des résistances 46a à 46h et seulement l'un des condensateurs 54a à 54h sont effectivement reliés au conducteur 32 et de même, seulement l'une des jonctions dans le diviseur de potentiel 68 est reliée au condensateur 72 à n'importe quel instant et en fonction de la vitesse de défilement choisie.

Pendant le fonctionnement, l'amplificateur différentiel 24 répond au signal provenant de la bobine 16 dans la tête de lecture 14 pour fournir des signaux correspondants mais en opposition de phase et à courant constant respectivement au condensateur 30 et à la combinaison du condensateur 38 et du gyrateur 42.

Le condensateur 30 fournit une réponse en fréquence sous la forme d'une ligne droite (sur un graphique logarithmique) dont la pente est de −6dB par octave comme le montre la figure 2 (c) en 100.

Dans le gyrateur 42, le signal d'entrée reçu à la base du transistor 40 est fourni, sans modification de la phase par ce transistor 40 qui fonctionne en mode émetteur chargé, au transistor 58 qui est branché en configuration base commune (gain élevé, déphasage nul). Lorsque le signal d'entrée est à basse fréquence (c'est à dire lorsque l'effet du condensateur qui a été choisi parmi les condensateurs 54 est relativement peu important), le signal amplifié provenant du transistor 58 est renvoyé avec une inversion de phase totale par l'intermédiaire du transistor à émetteur commun 44 à la base du transistor 40. Par conséquent, la base du transistor 40 présente une très faible impédance apparente. Cependant, au fur et à mesure que la fréquence du signal d'entrée augmente l'impédance du condensateur sélectionné 54 diminue, réduisant ainsi l'impédance au niveau du collecteur du transistor 58 et diminuant le niveau du signal de retour négatif traversant le transistor 44 de sorte que l'impédance apparente à la base du transistor 40 augmente également. Cette augmentation d'impédance en fonction de la fréquence est caractéristique d'une inductance. Par conséquent, le gyrateur 42 fournit, en association avec le condensateur 38 une réponse en fréquence résonnante semblable à celle de la combinaison en parallèle d'un condensateur de valeur $C_c$, d'une inductance L et d'une résistance r, où:

$$L \simeq R_c \times R_s \times C_s \qquad (1)$$

et $\qquad r \simeq R_c \times R_s / R_p \qquad (2)$

La définition des grandeurs $R_c$, $R_s$, $C_s$ et $R_p$ apparaît immédiatement sur la figure 1.

On peut montrer que l'impédance z (qui, pour une entrée à courant constant, est proportionnelle à la chute de tension) de cette combinaison en parallèle à une fréquence angulaire $\omega (= 2\pi \times$ fréquence f) est égale à:

$$z = r\omega L / [\omega L - jr (1 - \omega^2 L C_c)] \qquad (3)$$

La fréquence de résonnance $f_R$ est donnée par:

$$\omega_R^2 = 1/LC_c \qquad (4)$$

de sorte qu'à cette fréquence la formule (3) se simplifie en donnant:

$$z = r \qquad (5)$$

La courbe de réponse du gyrateur 42 est représentée dans la figure 2 (c) en 102: la partie représentée en trait continu s'élève avec une pente de +6 dB par octave; la partie en trait discontinu est le pic de résonnance qui est placé de telle manière à se trouver en dehors de la gamme de fréquences utiles couvertes par l'égaliseur.

Le rôle du transistor de sortie 36 est d'additionner les réponses en fréquence du condensateur 30 et de la combinaison du condensateur 38 avec le gyrateur 42 (il est à noter à cet égard que dans ce cas la nature intrinsèque en opposition de phase de ces réponses est compensée par l'apport de signaux en opposition de phase provenant de l'amplificateur différentiel 24). Pour des fréquences nettement supérieures à une octave de chaque côté de la fréquence à laquelle les réponses sont égales (par exemple, $f_1$ dans la figure 2 (c)), la réponse totale est pratiquement égale à la plus grande des deux réponses seules. Cependant, pour les fréquences proches de $\underline{f}$, les fréquences se renforcent notablement les unes les autres de façon à produire une réponse linéaire (représentée en pointillé en 104) au voisinage de la fréquence $f_1$. La réponse globale (100 associée à 102 par l'intermédiaire de 104) est très proche de la caractéristique souhaitée pour l'égaliseur représenté dans la figure 2 (b).

En outre, lorsque la vitesse de défilement est réduite d'un facteur 2, par exemple, (décalant ainsi le balai du commutateur 50 dans la direction de la borne $\underline{a}$) les valeurs $R_s$ et $C_s$ sont doublées. L'étude des formules (1) et (2) montre que L est ainsi quadruplé et que $\underline{r}$ est doublé. La formule (4) montre que $\omega R$ (et par conséquent $f_R$) est ainsi diminué de moitié. La substitution de ces variations dans la formule (3) montre que l'impédance $\underline{z}$ de la combinaison gyrateur 42 — condensateur 38 double pour une diminution de moitié de la fréquence sur la totalité de la gamme de fréquence. A propos de la figure 2 (c), cela a pour effet de déclarer la totalité de la réponse résonnante vers le haut de 6 dB et vers la gauche (vers les fréquences plus basses) d'une octave (comme le fait fet de décaler la totalité de la réponse résonnante $f_R$) jusqu'à la position indiquée en 106. La réponse totale fournie par le transistor de sortie 36 devient alors la réponse 100 associée à la réponse 106 par la réponse 108. On peut constater que cette réponse présente la même forme que celle qui a été décrite précédemment (100/104/102) mais avec un creux en $f_1/2$ et supérieur de 6dB. Ainsi, si la réponse 100/104/102 est ajustée de façon à ce que son impédance minimale et que la fréquence $f_1$ correspondent aux valeurs souhaitées pour l'égaliseur à une vitesse de défilement $v_1$, le passage à une vitesse de défilement $v_1/2$ aura pour effet de décaler automatiquement l'égaliseur vers la réponse 100/108/106 qui correspondra alors à la réponse requise à la vitesse $v_1/2$ (voir figure 2 (b)).

Comme il a été indiqué ci-dessus, la modification souhaitée en deux fois des valeurs $R_s$ et $C_s$ peut être effectuée avec une précision suffisante en utilisant des constituants à valeur fixe et à tolérances serrées. La réponse résonnante est ajustée par rapport à la réponse capacitive (pour ajuster la fréquence $f_1$ et l'impédance minimale relative correspondante) en faisant varier la valeur $R_G$ du rhéostat 64 ce qui a pour effet de déplacer les réponses 102 et 106 (et les réponses associées pour les autres vitesses de défilement) vers le haut et vers le bas par rapport à la réponse 100 du condensateur 30. Les valeurs absolues globales de l'impédance pour la totalité de la courbe de réponse sont ajustées au moyen du potentiomètre 82.

La faible variation de la courbe de réponse aux fréquences élevées de l'égaliseur nécessaire pour tenir compte des variations de la réponse en fréquence d'une piste à l'autre est fournie par le rhéostat 52. Comme le montrent les formules (2) et (5), sa valeur $R_p$ agit sur la valeur de r et par conséquent sur l'impédance à la fréquence de résonance $f_R$. Cependant la valeur $R_p$ a très peu d'effet sur la réponse dans les domaines des très hautes ou des très basses fréquences. Ainsi, une modification de la valeur $R_p$ du rhéostat 52 décale légèrement vers le haut ou vers le bas le pic d'impédance de chaque réponse sans modifier l'impédance aux fréquences très élevées ou très basses; par conséquent la pente des réponses telles que 102, 106 est modifiée, fournissant ainsi l'ajustement souhaité pour les différentes pistes $t_1$, $t_2$, etc. (voir figure 2 (b)).

Comme les constituants 52 et 64 ne sont pas affectés par le fonctionnement du commutateur 50, ils ajustent effectivement toutes les réponses 100/104/102, 100/108/106 etc., simultanément. Par conséquent seuls deux ajustements d'accordage au total sont nécessaires pour chaque piste par opposition aux trois ou quatre ajustements par vitesse pour chaque piste (en général 24 ou 32 par piste pour un enregistreur à 8 vitesses) qui étaient nécessaires antérieurement.

Le diviseur de potentiel 68 et le réseau de transistors de commutation 70 permettent de fournir une compensation de phase en fonction de la vitesse de défilement de la bande en combinant une composante (dont l'amplitude est choisie au moyen du diviseur de potentiel 68) dérivée du signal d'entrée à l'origine avec le signal égalisé. Par l'effet du condensateur 30 et du gyrateur 42, ce signal égalisé est en quadrature de phase avec le signal d'entrée d'origine de sorte que l'effet de cette combinaison est de déphaser le signal égalisé en fonction de ladite amplitude choisie pour la composante dérivée du signal d'entrée. En outre, le commutateur bipolaire 74 est prévu pour être déplacé de la position réprésentée, à son autre position au cas où l'on souhaite faire défiler la bande dans le sens inverse, de façon à ce que la composante du signal d'entrée d'origine reçue par le transistor de sortie 36, en provenance du diviseur de potentiel 68, soit inversée par l'amplificateur différentiel 80 de façon à provoquer le déphasage du signal égalisé dans l'autre sens. Ainsi, la compensation de phase requise en fonction de la vitesse de défilement est fournie en combinant le signal égalisé à une version commandée en amplitude du signal non égalisé initial. En outre, la compensation de phase pour une reproduction dans le sens inverse est obtenue en inversant simplement (déphasage de 180°) cette composante titrée du signal non égalisé.

Diverses modifications peuvent être apportées au circuit réprésenté dans la figure 1 selon les divers cas particuliers. C'est ainsi que la compensation de phase utilisée pour tenir compte du sens de défilement à la reproduction peut également être fournie en commutant sélectivement une première résistance en série avec le condensateur 30 pour la reproduction vers l'avant et une seconde résistance en série avec l'entrée du gyrateur 42 pour la reproduction en arrière.

Si l'on ne dispose que d'une gamme limitée de vitesses de défilement de la bande, une résistance 46 unique pourrait remplacer la résistance $R_s$ et il ne serait nécessaire de commuter que les condensateurs 54. Dans ce cas, il faudrait que les valeurs des condensateurs suivants quadruplent chaque fois qu'on divise par deux la vitesse de défilement et un rhéostat 52 séparé serait nécessaire en association avec chaque condensateur 54.

L'inversion de phase relative effectuée par l'amplificateur différentiel 24 pourrait en variante être réalisée dans le transistor de sortie 36 en reliant par exemple la sortie du gyrateur 42 à l'émetteur du transistor de sortie 36 et non à sa base. Une autre possibilité serait d'agencer le condensateur 30 et la combinaison condensateur 38 — gyrateur 42 de façon à recevoir le même signal d'entrée, de les brancher sous forme d'un circuit équivalent accordé en série, et d'appliquer les signaux filtrés combinés soit à un filtre à large bande pour une compensation de phase, soit à un réseau de compensation de phase, préréglé commuté en fonction de la vitesse de la bande et suivi d'un circuit additionnant sélectivement le signal non filtré avec ou sans inversion de la façon décrite ci-dessus.

## Revendications

1. Filtre accordé par commutation trouvant application dans un égaliseur pour enregistreur à bande magnétique, caractérisé en ce qu'il comporte:
— une entrée (24) pour recevoir un signal d'entrée;
— un filtre capacitif (30) relié et répondant à ladite entrée pour fournir un premier signal filtré;
— un filtre résonnant (38, 42) relié et répondant à ladite entrée pour fournir un second signal filtré, ledit filtre résonnant comportant un gyrateur et présentant une réponse en fréquence dépendant au moins en partie de valeurs des paramètres de circuit le long de deux trajets de circuit dans ledit gyrateur;
— des moyens de commutation (50, 48, 56) prévus pour sélectionner différentes valeurs des paramètres de circuit pour au moins l'un desdits trajets; et
— des moyens (36) reliés et répondant audit filtre capacitif et audit filtre résonnant pour combiner lesdits premier et second signaux filtrés.

2. Filtre suivant la revendication 1, caractérisé en ce que ledit filtre capacitif présente une réponse en fréquence purement capacitive.

3. Filtre suivant la revendication 1 ou la revendication 2, caractérisé en ce que lesdits moyens de commutation (50, 48, 56) sont agencés pour sélectionner différentes valeurs des paramètres du circuit pour chacun desdits trajets.

4. Filtre suivant la revendication 3, caractérisé en ce que lesdits moyens de commutation (50, 48, 56) sont agencés pour sélectionner différentes valeurs ($R_s$) de résistance dans l'un desdits trajets du circuit et différentes valeurs ($C_s$) de capacité dans l'autre trajet.

5. Filtre suivant la revendication 4, caractérisé en ce que lesdits moyens de commutation (50, 48, 56) sont prévus pour sélectionner des valeurs qui doublent successivement.

6. Filtre suivant la revendication 4 ou la revendication 5, caractérisé en ce que ledit autre trajet comprend des moyens à résistance variable (52) en série avec lesdites capacités sélectionnables.

7. Filtre suivant l'une quelconque des revendications précédentes, caractérisé en ce que ledit filtre résonnant est relié auxdits moyens de combinaison (36) par des moyens amplificateurs à gain variable.

8. Filtre suivant l'une quelconque des revendications précédentes, caractérisé en ce que ledit filtre résonnant comprend une capacité (38) à valeur fixe ($C_c$) en parallèle avec ledit gyrateur.

9. Filtre suivant l'une quelconque des revendications précédentes, caractérisé en ce que lesdits moyens de combinaison (36) sont prévus pour additionner lesdits premier et second signaux filtrés.

10. Filtre suivant l'une quelconque des revendications précédentes, caractérisé en ce que ladite entrée (24) est prévue pour fournir des signaux en opposition de phase audit filtre capacitif (30) et audit filtre résonnant (38, 42) respectivement.

11. Filtre suivant l'une quelconque des revendications précédentes, caractérisé en ce qu'il comporte des moyens de commande d'amplitude (68) reliés et répondant à ladite entrée pour fournir un signal commandé en amplitude, et en ce que lesdits moyens de combinaison (36) sont reliés et répondent auxdits moyens de commande d'amplitude en combinant ledit signal commandé en amplitude auxdits signaux filtrés.

12. Filtre suivant la revendication 11, caractérisé en ce que lesdits moyens de commande d'amplitude (68) sont reliés auxdits moyens de combinaison (36) par l'intermédiaire de moyens (74, 80) permettant d'inverser sélectivement ledit signal commandé en amplitude.

13. Filtre suivant la revendication 11 ou 12, caractérisé en ce que les moyens de commande d'amplitude comportent un diviseur de potentiel (68).

14. Enregistreur à bande magnétique caractérisé en ce qu'il comporte un égaliseur comprenant un filtre accordé par commutation suivant l'une quelconque des revendications précédentes.

## Patentansprüche

1. Durch Umschaltung abgestimmtes Filter zur Anwendung in einem Entzerrer für Magnetband-Aufzeichnungsgeräte, dadurch gekennzeichnet, dass es umfasst:
— einen Eingang (24) zum Empfangen eines Eingangssignals;
— ein kapazitives Filter (30), das an den Eingang angeschlossen ist und auf diesen anspricht, um ein erstes gefiltertes Signal zu liefern;
— ein Resonanzfilter (38, 42), das mit dem genannten Eingang verbunden ist und auf diesen anspricht, um ein zweites gefiltertes Signal zu liefern, wobei das genannte Resonanzfilter einen Gyrator enthält und eine Frequenzkurve aufweist, die wenigstens teilweise von Parameterwerten der Schaltung entlang zwei Schaltungswegen in dem genannten Gyrator abhängt;
— Schalteinrichtungen (50, 48, 56), die vorgesehen sind, um verschiedene Parameterwerte der Schaltung für wenigstens einen der Schaltungswege auszuwählen; und
— Mittel (36), die angeschlossen sind an und ansprechen auf das genannte kapazitive Filter und das Resonanzfilter, zum Kombinieren der ersten und zweiten gefilterten Signale.

2. Filter nach Anspruch 1, dadurch gekennzeichnet, dass das genannte kapazitive Filter eine rein kapazitive Frequenzkurve aufweist.

3. Filter nach Anspruch 1 oder Anspruch 2, dadurch gekennzeichnet, dass die genannte Schalteinrichtungen (50, 48, 56) so ausgebildet sind, dass sie verschiedene Parameterwerte der Schaltung für jeden der Schaltungswege auswählen.

4. Filter nach Anspruch 3, dadurch gekennzeichnet, dass die genannten Schalteinrichtungen (50, 48, 56) so ausgebildet sind, dass sie verschiedene Widerstandswerte ($R_s$) in einem der Schaltungswege und verschiedene Kapazitätswerte ($C_s$) in dem anderen Weg auswählen.

5. Filter nach Anspruch 4, dadurch gekennzeichnet, dass die genannten Schalteinrichtungen (50, 48, 56) vorgesehen sind, um Werte auszuwählen, die sich sukzessive verdoppeln.

6. Filter nach Anspruch 4 oder Anspruch 5, dadurch gekennzeichnet, dass der genannte andere Schaltungsweg variable Widerstandsmittel (52) in Reihe mit den wählbaren Kapazitäten umfasst.

7. Filter nach einem der vorstehenden Ansprüche, dadurch gekennzeichnet, dass das genannte Resonanzfilter mit den genannten Kombinationsmitteln (36) über Verstärkermittel mit veränderlicher Verstärkung verbunden ist.

8. Filter nach einem der vorstehenden Ansprüche, dadurch gekennzeichnet, dass das Resonanzfilter eine Kapazität (38) mit festem Wert ($C_c$) parallel zu dem Gyrator enthält.

9. Filter nach einem der vorstehenden Ansprüche, dadurch gekennzeichnet, dass die genannten Kombiniermittel (36) vorgesehen sind, um die ersten und zweiten gefilterten Signale zu addieren.

10. Filter nach einem der vorstehenden Ansprüche, dadurch gekennzeichnet, dass der genannte Eingang (24) vorgesehen ist, um Signale mit entgegengesetzter Phase dem kapazitiven Filter (30) bzw. dem Resonanzfilter (38, 42) zuzuführen.

11. Filter nach einem der vorstehenden Ansprüche, dadurch gekennzeichnet, dass es Amplitudensteuermittel (68) enthält, die angeschlossen sind an und ansprechen auf den genannten Eingang, um ein amplitudengesteuertes Signal zu liefern, und dass die genannten Kombiniermittel (36) angeschlossen sind an und ansprechen auf die genannten Amplitudensteuermittel, indem sie das amplitudengesteuerte Signal mit den gefilterten Signalen kombinieren.

12. Filter nach Anspruch 11, dadurch gekennzeichnet, dass die genannten Amplitudensteuermittel (68) mit den genannten Kombiniermitteln (36) über Mittel (74, 80) verbunden sind, die es ermöglichen, das amplitudengesteuerte Signal selektiv zu invertieren.

13. Filter nach Anspruch 11 oder 12, dadurch gekennzeichnet, dass die Amplitudensteuermittel einen Potentialteiler (68) enthalten.

14. Magnetband-Aufzeichnungsgerät, dadurch gekennzeichnet, dass es einen Entzerrer mit einem durch Umschaltung abgestimmten Filter nach einem der vorstehenden Ansprüche enthält.

**Claims**

1. A switch-tuned filter for use in an equaliser in a magnetic tape recorder, characterised by:
— input means (24) arranged to receive an input signal;
— a capacitive filter (30) responsively coupled to said input means to provide a first filtered signal;
— a resonant filter (38, 42) responsively coupled to said input means to provide a second filtered signal, said resonant filter including a gyrator and having a frequency response dependent at least in part on circuit values in two circuit paths in said gyrator;
— switch means (50, 48, 56) arranged to select different circuit values in at least one of said paths, and
— means (36) responsively coupled to said capacitive filter and said resonant filter to combine said first and second filtered signals.

2. A filter according to claim 1, characterised in that said capacitive filter has a purely capacitive frequency response.

3. A filter according to claim 1 or claim 2, characterised in that said switch means (50, 48, 56) is arranged to select different circuit values in each of said paths.

4. A filter according to claim 3, characterised in that said switch means (50, 48, 56) is arranged to select different resistive values ($R_s$) in one of said circuit paths and different capacitive values ($C_s$) in the other path.

5. A filter according to claim 4, characterised in that said switch means is arranged to select values which successively double.

6. A filter according to claim 4 or claim 5, characterised in that said other path includes variable resistive means (52) in series with said selectable capacitive values.

7. A filter according to any preceding claim, characterised in that said resonant filter is coupled to said combining means (36) via variable-gain amplifier means.

8. A filter according to any preceding claim, characterised in that said resonant filter comprises fixed-value capacitance (38) means in parallel with said gyrator.

9. A filter according to any preceding claim, characterised in that said combining means (36) is arranged to sum said first and second filtered signals.

10. A filter according to any preceding claim, characterised in that said input means (24) is arranged to provide anti-phase signals to said capacitive filter (30) and said resonant filter (38, 42) respectively.

11. A filter according to any preceding claim, characterised by amplitude-control means (68) responsively coupled to said input means to provide a controlled-amplitude signal, and in that said combining means (36) is responsively coupled to said amplitude-control means to combine said controlled-amplitude signal with said filtered signals.

12. A filter according to claim 11, characterised in that said amplitude-control means (68) is coupled to said combining means (36) via means (74, 80) for selectively inverting said controlled-amplitude signal.

13. A filter according to claim 11 or claim 12, characterised in that said amplitude-control means comprises a potential divider (68).

14. A magnetic tape recorder characterised by an equaliser including a switch-tuned filter according to any preceding claim.

Fig.1

Fig. 2

0 028 549